# EUROPÄISCHE PATENTSCHRIFT

(11) **EP 3 570 319 B1**
(45) Veröffentlichungstag und Bekanntmachung des Hinweises auf die Patenterteilung: **12.06.2024**
(21) Anmeldenummer: 19000216.2
(22) Anmeldetag: 06.05.2019
(51) Int. Cl.: H01L 21/763, H01L 21/78, H01L 21/265, H01L 23/31

(54) **HALBLEITERBAUELEMENTHERSTELLUNGSVERFAHREN UND HALBLEITERBAUELEMENT**
SEMICONDUCTOR MODULE MANUFACTURING METHOD AND SEMICONDUCTOR MODULE
PROCÉDÉ DE FABRICATION DE COMPOSANT SEMI-CONDUCTEUR ET COMPOSANT SEMI-CONDUCTEUR

(30) Priorität: 17.05.2018 DE 102018003982
(43) Veröffentlichungstag der Anmeldung: 20.11.2019
(73) Patentinhaber: 3-5 Power Electronics GmbH, 01217 Dresden (DE)
(72) Erfinder: Dudek, Volker, 76275 Ettlingen (DE)
(74) Vertreter: Koch Müller Patentanwaltsgesellschaft mbH

(56) Entgegenhaltungen:
- EP-A2- 0 335 720
- JP-A- H11 307 806
- US-A1- 2005 130 390
- US-A1- 2008 032 488
- D'AVANZO D C: "PROTON ISOLATION FOR GAAS INTEGRATED CIRCUITS", IEEE TRANSACTIONS ON MICROWAVE THEORY AND TECHNIQUES, PLENUM, USA, Bd. MTT-30, Nr. 7, 1. Juli 1982 (1982-07-01), Seiten 955-963, XP000835537, ISSN: 0018-9480, DOI: 10.1109/TMTT.1982.1131183

## Beschreibung

Die Erfindung betrifft eine Halbleiterbauelementherstellungsverfahren sowie ein und Halbleiterbauelement.

Zur Herstellung von Halbleiterbauelementen werden typischerweise komplette Halbleiterscheiben, auch Wafer genannt, prozessiert und anschließend in einzelne Chips separiert.

Aus der US 2008/032488 A1 ist beispielsweise ein Verfahren zum Anordnen und Vereinzeln von auf einem Substrat angeordneten Bauelementen bekannt, wobei vor dem Vereinzeln auf den Seitenflächen der Bauelemente eine Passivierungsschicht aufgebracht wird. Des Weiteren sind aus JP H11 307806 A und der EP 0 335 720 A2 Verfahren zum Anordnen und Vereinzeln von auf einem Substrat angeordneten Bauelementen bekannt.

Das Vereinzeln erfolgt insbesondere durch Sägen, Ritzen, Brechen, mittels eines Lasers oder eines Plasmaätzens oder eine Kombination der genannten Verfahren.

Im Allgemeinen wird entlang des Ritzrahmens von der Oberseite des Wafers bis auf das Substrat geätzt. Der Ätzprozess wird auch als MESA-Ätzung bezeichnet. Anschließend wird das Substrat durchgesägt. Im Allgemeinen ist der Ätzgraben breiter als die Säge und es bildet sich ein umlaufender Rand aus.

Vor diesem Hintergrund besteht die Aufgabe der Erfindung darin, ein Verfahren und eine Vorrichtung anzugeben, die den Stand der Technik weiterbildet.

Die Aufgabe wird durch ein Halbleiterbauelementherstellungsverfahren mit den Merkmalen des Patentanspruchs 1 sowie durch ein stapelförmiges Halbleiterbauelement mit den Merkmalen des Patentanspruchs 13 gelöst. Vorteilhafte Ausgestaltungen der Erfindung sind jeweils Gegenstand von Unteransprüchen.

Ein Gegenstand der Erfindung ist ein Halbleiterbaueelementherstellungsverfahren, wobei ein Halbleiterhalbzeug mit einer Oberseite und einer Unterseite bereitgestellt wird.

Das Halbleiterhalbzeug umfasst eine Vielzahl von zueinander benachbarten stapelförmig ausgebildeten Halbleiterbauelemente, wobei die Halbleiterbauelemente jeweils eine Substratschicht mit einem III-V Material oder mit Germanium aufweisen.

Die Substratschicht ist an oder in der Nähe der Unterseite angeordnet. Auf der Substratschicht ist eine erste Halbleiterschicht von einem ersten Leitfähigkeitstyp angeordnet.

Auf der ersten Halbleiterschicht ist mindestens eine zweite Halbleiterschicht von einem zweiten Leitfähigkeitstyp angeordnet, wobei die beiden Halbleiterschichten jeweils ein III-V Material umfassen oder aus einem III-V Material bestehen und die beiden Leitfähigkeitstypen unterschiedlich sind.

Zwischen zwei unmittelbar benachbarten Halbleiterbauelementen wird auf der Oberseite des Halbleiterhalbzeugs ein Ritzrahmen mit einer Breite L1 ausgebildet.

Die Halbleiterbauelemente werden entlang des Ritzrahmens vereinzelt.

Auf der Oberseite des Halbleiterhalbzeugs wird vor dem Vereinzeln eine die Halbleiterbauelemente bedeckende und wenigstens einen Teil des Ritzrahmens freilassende Maskenschicht aufgebracht.

Nach dem Aufbringen der Maskenschicht wird eine Ionenimplantation zur Isolierung und/oder wenigstens teilweise Amorphisierung durchgeführt.

Die Ionenimplantation umfasst wenigstens einen Implantationsschritt mit einer Energie von wenigstens 500 keV.

Nach der Ionenimplantation wird die Maskenschicht entfernt. Nach der Entfernung der Maskenschicht werden die Halbleiterbauelemente vereinzelt.

Als ein weiterer Gegenstand der Erfindung wird ein stapelförmiges Halbleiterbauelement bereitgestellt.

Das stapelförmige Halbleiterbauelement weist eine Oberseite und eine Unterseite auf. Des Weiteren weist das Halbleiterbauelement eine die Oberseite mit der Unterseite verbindende Seitenfläche auf.

Die Unterseite wird von der Substratschicht und / oder unterhalb von der Substratschicht angeordnete Rückseitenkontaktschicht ausgebildet.

Auf der Substratschicht ist jeweils eine erste Halbleiterschicht von einem ersten Leitfähigkeitstyp angeordnet. Auf der ersten Halbleiterschicht ist mindestens eine zweite Halbleiterschicht von einem zweiten Leitfähigkeitstyp angeordnet.

Dei beiden Halbleiterschichten umfassen ein III-V Material oder bestehen aus einem III-V Material. Die beiden Leitfähigkeitstypen sind unterschiedlich, d.h. weisen eine unterschiedliche Polarität auf.

Entlang der Seitenfläche ist ein bis zu einer Tiefe sich erstreckender amorphisierter und oder isolierender Bereich ausgebildet. Die Richtung der Tiefe ist senkrecht zu dem Schichtstapel ausgebildet.

Als Ritzrahmen werden die Bereiche der Oberfläche des Halbleiterhalbzeugs bzw. Wafers bezeichnet, entlang derer das Halbleiterhalbzeug geteilt bzw. vereinzelt werden soll.

Mittels des Ritzrahmens wird die Vielzahl auf der Halbleiterscheibe ausgebildeten separaten Bauelementstrukturen voneinander getrennt.

Die Maskenschicht lässt die Ritzrahmen frei, d.h. die Maskenschicht weist entsprechende Öffnungen auf. Durch die Öffnungen bleiben Bereiche zwischen unmittelbar benachbarten Bauelementen zugänglich.

Vorzugsweise werden mittels der Maskenschicht, bzw. durch die Breite der Öffnungen in der Maskenschicht, zusätzlich zu den Implantationsbereichen auch die Position und insbesondere die Breite des Ritzrahmens vorgegeben.

Mittels der Ionenimplantation werden die Kristallstruktur und die Leitfähigkeit in dem Bereich des Ritzrahmens wenigstens teilweise zerstört. Es versteht sich, dass die Temperatur in allen gegebenenfalls folgenden Verarbeitungsschritten des Halbleiterhalbzeugs nicht so hoch sein darf, dass die durch die Implantation in den implantierten Bereichen des Ritzrahmens erzeugten Kristalldefekte wieder ausheilen.

Anders ausgedrückt, sofern nach der Ionenimplantation keine Ausheilschritte durchgeführt werden, bleibt der Bereich des Ritzrahmens bis in einer durch die Eindringtiefe der Ionen vorgegebenen Tiefe teilweise oder vollständig isoliert. Es versteht sich, dass die bei dem Vereinzeln, insbesondere durch Sägen benötige Breite kleiner als die Breite des mit der Ionenimplantation bestrahlten Bereiches ist.

Die bei dem Vereinzeln entstehenden Seitenflächen und seitliche Bereiche bzw. Ränder sind elektrisch isolierend ausgebildet.

Sofern keine MESA-Ätzung durchgeführt wird, bilden sich durch bei der Vereinzelung, beispielsweise durch Sägen, vorzugsweise senkrechte Seitenfläche aus. Höchst vorzugsweise sind die Seitenflächen vollständig senkrecht.

Ein Vorteil ist es, dass insbesondere bei hochsperrenden Bauelementen mit einer Sperrspannung oberhalb von 100 V oder oberhalb von 1000 V Leckströme oder Nebenschlüsse über den Rand hinweg wirkungsvoll unterdrückt werden.

Ein anderer Vorteil des erfindungsgemäßen Verfahrens ist es, dass der Bereich des Ritzrahmens bis zu dem Vereinzeln nahezu plan oder vollständig plan ist und keine oder in einer alternativen Ausführung nur eine kurze Mesaätzung vor dem Vereinzeln durchgeführt wird. Ein anderer Vorteil ist, dass sich ohne aufwändige und problematische MESA-Ätzprozesse auch Halbleiterbauelemente mit einer Stapelhöhe oberhalb 50 µm einfach und zuverlässig voneinander trennen lassen.

Ein weiterer Vorteil ist, dass sich mittels der Amorphisierung Spannungen durch das Vereinzeln auf die Halbleiterbauelementen unterdrücken lassen.

Gemäß einer ersten Ausführungsform umfassen die erste Halbleiterschicht und die zweite Halbleiterschicht jeweils eine GaAs-Verbindung oder bestehen aus einer GaAs-Verbindung.

In einer weiteren Ausführungsform wird mittels der Ionenimplantation ein Tiefenbereich zwischen der Oberseite des Halbleiterhalbzeugs bis zu der ersten Halbleiterschicht oder ein Tiefenbereich zwischen der Oberseite des Halbleiterhalbzeugs bis einschließlich der zweiten Halbleiterschicht oder ein Tiefenbereich zwischen der Oberseite des Halbleiterhalbzeugs bis zu der Substratschicht amorphisiert und/oder isoliert.

In einer Weiterbildung werden Wasserstoff-Ionen oder Helium-Ionen implantiert.

In einer anderen Weiterbildung wird eine Beschleunigungsenergie der Ionen während der Implantation zwischen einem Minimalwert und einem Maximalwert verändert, wobei der Minimalwert mindestens 50 keV beträgt und der Maximalwert höchstens 300 MeV beträgt.

Es versteht sich, dass der Maximalwert und der Minimalwert die maximale bzw. minimale Eindringtiefe der Ionen bestimmen. Die Änderung der Energie erfolgt bevorzugt kontinuierlich, lässt sich aber auch stufenförmig oder in jeder beliebigen anderen Weise durchführen.

Eine Implantationsdosis während der Implantation beträgt bevorzugt zwischen 10¹⁰ N / cm⁻² und 10¹⁶ N / cm⁻².

Gemäß einer anderen Weiterbildung wird die Maskenschicht vor oder nach dem Sägen durch Ätzverfahren entfernt, insbesondere lassen sich nasschemische Verfahren anwenden.

Es versteht sich, dass sich das Ätzverfahren nach dem Material der Maskenschicht richtet. So lässt sich eine aus Aluminium bestehende Maskenschicht beispielsweise mittels Salzsäure bzw. Chlorwasserstoff (HCl) entfernen, eine aus Titan bestehende Maskenschicht z.B. mittels Schwefelsäure (H₂SO₄).

In einer weiteren Ausführungsform weist das Halbleiterhalbzeug vor dem Aufbringen der Maskenschicht auf der Oberseite und / oder auf der Unterseite metallische Kontaktflächen auf. Vorzugsweise umfassen die Kontaktflächen auf der Oberseite und/ oder auf der Unterseite Gold und/oder Palladium.

Alternativ ist es möglich, die Metallisierung, also das Aufbringen von Kontaktflächen, z.B. Pads und/oder Leiterbahnen, erst nach der Implantation und dem Entfernen der Maskenschicht durchzuführen. Hierbei bedeckt die Maskenschicht auch die Kontaktflächen an der Oberseite.

In einer anderen Weiterbildung wird vor dem Aufbringen der Maskenschicht die Oberseite des Halbleiterhalbzeugs mittels chemischer Gasphasenabscheidung mit einer Passivierungsschicht mit einer Schichtdicke von mindestens 100 nm beschichtet wird.

Es versteht sich, dass in diesem Fall die Oberseite des Halbleiterhalbzeugs auch oder vollständig durch die Passivierungsschicht ausgebildet wird und die Maskenschicht entsprechend auf der Passivierungsschicht angeordnet wird.

Das Aufbringen der Passivierungsschicht vor der Implantation vereinfacht die Fertigung insofern, als dass die Passivierungsschicht auch als Ätzstoppschicht für ein späteres Entfernen der Maskenschicht dient.

Die Halbleiterscheibe ist nahezu fertig prozessiert und die Maskenschicht lässt sich nach der Implantation auf einfache Weise, z.B. mittels eines Trockenätzprozesses oder nasschemischen Ätzprozesses entfernen.

Die Passivierungsschicht wird bevorzugt plasmaunterstützt aufgebracht (PECVD). Bevorzugt umfasst die Passivierungsschicht SiO2 oder Si3N4.

Gemäß einer weiteren Weiterbildung wird die Passivierungsschicht vor dem Aufbringen der Maskenschicht von mindestens einer auf der Oberfläche des Hableiterhalbzeugs angeordneten Kontaktfläche mittels Trockenätzens entfernt.

In einer anderen Ausführungsform wird durch die Ionenimplantation der Ritzrahmen auf einer Breite von mindestens 30 µm und höchstens 300 µm amorphisiert und/oder isolierend ausgebildet.

In einer alternativen Ausführungsform wird die Breite des Ritzrahmens durch die Breite der Öffnung in der Maskenschicht bestimmt. Es versteht sich, dass hierdurch der Ritzrahmen auf der gesamten Breite amorphisiert ist.

In einer Weiterbildung wird für die Maskenschicht ein Metall insbesondere Titan oder Aluminium verwendet. Ein Vorteil der Verwendung einer Metallmaske besteht in der im Verhältnis zu den Halbleiterschichten geringen Eindringtiefe der Ionen. Hierdurch werden die unter der Maskenschicht ausgebildeten Halbleiterbereiche zuverlässig vor einer Beschädigung bzw. Amorphisierung auch bei hohen Energien geschützt.

In einer anderen Weiterbildung umfassen die erste Halbleiterschicht und die zweite Halbleiterschicht jeweils eine GaAs-Verbindung oder bestehen aus einer GaAs-Verbindung.

In einer Ausführungsform beträgt die Tiefe der teilweisen oder vollständigen Amorphisierung/Isollerung mindestens 0,5 µm oder mindestens 5 µm oder mindestens 30 µm oder alternativ wird ein Tiefenbereich zwischen der Oberseite bis zu der ersten Halbleiterschicht oder ein Tiefenbereich zwischen der Oberseite bis einschließlich der zweiten Halbleiterschicht oder ein Tiefenbereich zwischen der Oberseite bis zu der Substratschicht ausgebildet. Der gesamte teilweise oder vollständig amorphislerte/isolierte Bereich des Ritzrahmens wird nachfolgend auch als Zwischenbereich bezeichnet.

In einer Ausführungsform wird die Maskenschicht unmittelbar auf die freiliegenden metallischen Kontaktflächen angeordnet. Vorzugsweise sind die Metalle der Kontaktflächen chemisch selektiv gegen einen nasschemischen Ätzschritt zur Entfernung der metallischen Maskenschicht, z.B. mit HCl. Hierdurch vereinfacht sich die Herstellung und reduziert die Herstellungskosten.

In einer anderen Ausführungsform weist das Halbleiterbauelement eine Höhe H1 von mindestens 100 µm und höchstens 1000 µm auf. Vorzugsweise umfasst das Bauelement eine hochsperrende GaAs Leistungsdiode mit einer Sperrspannung oberhalb 600 Volt oder einen IGBT mit einer Sperrspannung oberhalb 500 V.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: einen Ausschnitt einer ersten erfindungsgemäßen Ausführungsform eines scheibenförmigen Halbleiterhalbzeugs,
- Figur 2: eine Ansicht einer ersten erfindungsgemäßen Ausführungsform eines stapelförmigen Halbleiterbauelements,
- Figur 3: ein Diagramm der Beschleunigungsenergie der Ionen gemäß einer ersten Ausführungsform des erfindungsgemäßen Halbleiterbauelementherstellungsverfahrens.

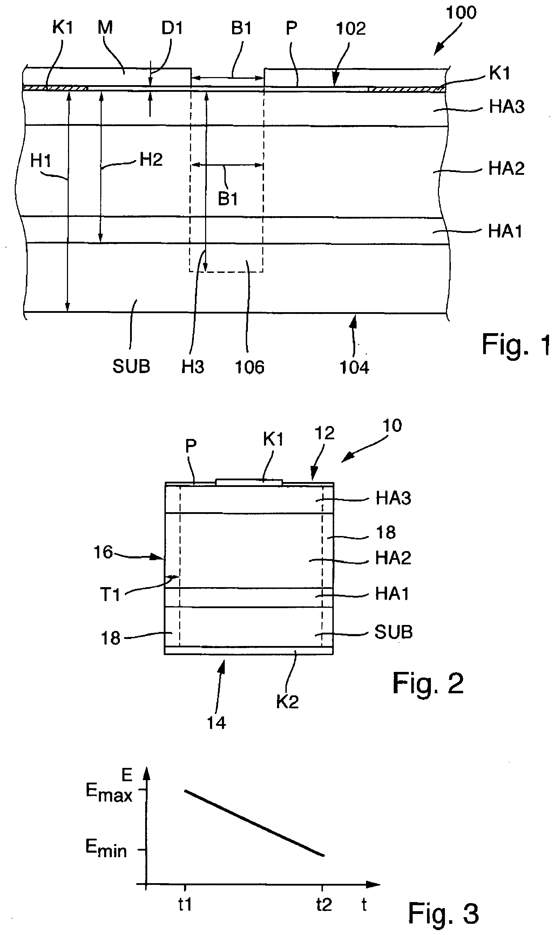

Die Abbildung der Figur 1 zeigt einen Ausschnitt einer ersten Ausführungsform eines scheibenförmigen Halbleiterhalbzeugs 100, aufweisend eine Oberseite 102 und eine Unterseite 104. Das Halbleiterhalbzeugs 100 weist von der Unterseite 104 bis zu der Oberseite 102 eine Gesamthöhe H1 auf.

Die Unterseite 104 wird durch eine Substratschicht SUB ausgebildet. Auf der Substratschicht SUB sind drei Halbleiterschichten HA1, HA2, HA3 stapelförmig angeordnet. Die Halbleiterschicht HA1, HA2 und HA3 weisen zusammen eine Höhe H2 auf. Auf der Oberfläche der obersten Halbleiterschicht H3 sind mehrere Kontaktflächen K1 angeordnet. Die Kontaktflächen K1 umfassen Pad sowie Leiterbahnen. Der nicht von Kontaktflächen K1 bedeckte Teil der Oberfläche der obersten Halbleiterschicht HA3 und ein Teil der Kontaktflächen, nämlich die Leiterbahnen, sind mit einer Passivierungsschicht P mit einer Dicke D1 bedeckt, so dass die Obersite 102 des Halbleiterhalbzeugs 100 von der Passivierungsschicht P und den freien Teil der Kontaktflächen K1, also den Pads, gebildet wird.

Auf der Oberseite 102 des Halbleiterhalbzeugs ist eine strukturierte Maskenschicht M angeordnet. Die Maskenschicht M lässt mehrere Ritzrahmen mit einer Linienbreite B1 auf der Oberseite 102 frei. Die Maskenschicht bedeckt somit nicht die Ritzrahmen und nur den Übrigen Teil der Oberseite 102 bzw. weist entsprechende Fenster auf.

Entlang des Ritzrahmens schließt sich ein in das Halbleiterhalbzeug hineinreichender Zwischenbereich 106 an, der gestrichelt dargestellt ist. Der Zwischenbereich 106 weist eine Höhe H3 auf, wobei die Höhe H3 größer oder gleich der Summe aus der Höhe H2 der Halbleiterschichten HA1, HA2 und HA3 und der Dicke D1 der Passivierungsschicht P ist. Eine Breite B1 der Zwischenschicht entspricht der Breite B1 des Ritzrahmens bzw. der Breite des Fensters der Maskenschicht M. Das Halbleitermaterial in der Zwischenbereich 106 ist durch eine Ionenimplantation amorphisiert und/oder isolierend.

Nach dem Vereinzeln des Halbleiterhalbzeugs 100, z.B. durch Sägen entlang des Ritzrahmens, und dem Entfernen der Maskenschicht 100, z.B. durch Trockenätzen, liegt ein erfindungsgemäßen stapelförmiges Halbleiterbauelement mit amorphisierten und/oder isolierend Seitenflächen vor.

In der Abbildung der Figur 2 ist eine erste Ausführungsform eines erfindungsgemäßen stapelförmigen Halbleiterbauelements 10 dargestellt. Das Halbleiterbauelement 10 weist eine Oberseite 12, eine Unterseite 14 sowie vier die Oberseite 12 mit der Unterseite 14 verbindende Seitenflächen 16 auf.

Das Halbleiterbauelement 10 umfasst einen Stapel aus einer Substratschicht, gefolgt von einer ersten Halbleiterschicht HA1, einer zweiten Halbleiterschicht HA2 und einer dritten Halbleiterschicht HA3. Auf einer Oberseite der dritten Halbleiterschicht HA3 ist ein Kontaktpad als eine Kontaktfläche K1 angeordnet. Der nicht von der Kontaktfläche K1 bedeckte Bereich der Oberseite der dritten Halbleiterschicht HA3 ist mit einer Passivierungsschicht P beschichtet. Die Passivierungsschicht P und die Kontaktfläche K1 bilden die Oberseite 12 des Halbleiterbauelements 10 aus. Eine Unterseite der Substratschicht SUB ist vollständig mit einer Kontaktschicht als Rückseitenkontakt K2 beschichtet. Der Rückseitenkontakt K2 bildet die Unterseite 14 des Halbleiterbauelements 10 aus.

Ein sich von der Oberseite 12 entlang der vier Seitenflächen 14 bis zu der zweiten Kontaktfläche K2 und von jeder Seitenfläche 16 bis zu einer Tiefe T1 erstreckender Bereich 18 des Halbleiterbauelements 10 ist durch Implantation amorphisiert und/oder isolierend, wobei die Tiefe T1 jeweils senkrecht zu der jeweiligen Seitenfläche verläuft.

In der Abbildung der Figur 3 ist eine Beschleunigungsenergie der Ionen als Funktion der Zeit für eine Implantation gemäß einer ersten Ausführungsform des erfindungsgemäßen Halbleiterbaueelementherstellungsverfahrens dargestellt. Die Implantation von Ionen zur Erzeugung von amorphisierten Zwischenbereichen entlang des Ritzrahmens eines Wafers beginnt zu einem Zeitpunkt t1 und endet zu einem Zeitpunkt t2. Zu Beginn weisen die Ionen eine Beschleunigungsenergie Eₘₐₓ auf, anschließend wird die Beschleunigungsenergie kontinuierlich reduziert, bis die Beschleunigungsenergie zum Zeitpunkt t2 nur noch einen Wert Eₘᵢₙ beträgt.

## Patentansprüche

1. Halbleiterbaueelementherstellungsverfahren, wobei
- ein Halbleiterhalbzeug (100) mit einer Oberseite (102) und einer Unterseite (104) bereitgestellt wird, aufweisend eine Vielzahl von zueinander benachbarten stapelförmig ausgebildeten Halbleiterbauelemente (10), wobei die Halbleiterbauelemente (10) jeweils eine Substratschicht (SUB) mit einem III-V Material oder mit Germanium aufweisen und die Substratschicht (SUB) an oder in der Nähe der Unterseite (104) angeordnet ist, und auf der Substratschicht (SUB) jeweils eine erste Halbleiterschicht (HA1) von einem ersten Leitfähigkeitstyp angeordnet und auf der ersten Halbleiterschicht (HA1) mindestens eine zweite Halbleiterschicht (HA2) von einem zweiten Leitfähigkeitstyp angeordnet ist, wobei die beiden Halbleiterschichten (HA1, HA2) ein III-V Material aufweisen oder aus einem III-V Material bestehen und die beiden Leitfähigkeitstypen unterschiedlich sind, und zwischen zwei unmittelbar benachbarten Halbleiterbauelementen (10) auf der Oberseite (102) des Halbleiterhalbzeugs (100) ein Ritzrahmen mit einer Breite (B1) ausgebildet ist, - vor dem Aufbringen einer Maskenschicht (M) die Oberseite (102) des Halbleiterhalbzeugs (100) mittels chemischer Gasphasenabscheidung mit einer Passivierungsschicht (P) mit einer Schichtdicke von mindestens 100 nm beschichtet wird, und - auf der Oberseite (102) des Halbleiterhalbzeugs (100) vor Vereinzeln eine die Halbleiterbauelemente (10) bedeckende und wenigstens einen Teil des Ritzrahmens freilassende Maskenschicht (M) aufgebracht wird, und
- nach dem Aufbringen der Maskenschicht (M) eine Ionenimplantation zur wenigstens teilweise Amorphisierung und/oder Isolierung durchge führt wird und die Ionenimplantation wenigstens einen Implantationsschritt mit einer Energie von wenigstens 500 keV aufweist, und
- nach der Ionenimplantation die Maskenschicht (M) entfernt wird, und - nach der Entfernung der Maskenschicht (M) Halbleiterbauelemente (10) entlang des Ritzrahmen vereinzelt werden.

2. Halbleiterbauelementherstellungsverfahren nach Anspruch 1, **dadurch gekennzeichnet, dass** die erste Halbleiterschicht (HA1) und die zweite Halbleiterschicht (HA2) jeweils eine GaAs-Verbindung aufweisen oder aus einer GaAs-Verbindung bestehen.

3. Halbleiterbauelementherstellungsverfahren nach Anspruch 1 oder 2, wobei mittels der Ionenimplantation ein Tiefenbereich zwischen der Oberseite (102 bis zu der ersten Halbleiterschicht (HA1) oder ein Tiefenbereich zwischen der Oberseite (102) und einschließlich der zweiten Halbleiterschicht (HA2) oder ein Tiefenbereich zwischen der Oberseite (102) bis Substratschicht (SUB) amorphisiert und/oder isoliert wird.

4. Halbleiterbauelementherstellungsverfahren nach einem der vorangegangenen Ansprüche, wobei dass Wasserstoff-Ionen und/oder Helium-Ionen implantiert werden.

5. Halbleiterbauelementherstellungsverfahren nach einem der vorangegangenen Ansprüche,wobei eine Beschleunigungsenergie (E) der Ionen während der Implantation zwischen einem Minimalwert (Emin) und einem Maximalwert (Emax) verändert wird, wobei der Minimalwert (Emin) mindestens 50keV beträgt und der Maximalwert (Emax) höchstens 300 MeV beträgt.

6. Halbleiterbauelementherstellungsverfahren nach einem der vorangegangenen Ansprüche, wobei eine Implantationsdosis während der Implantation zwischen 1010 cm⁻² und 1016 cm⁻² beträgt.

7. Halbleiterbauelementherstellungsverfahren nach einem der vorangegangenen Ansprüche, **dadurch gekennzeichnet, dass** die Maskenschicht (M) vor dem Vereinzeln durch ein nasschemisches Ätzverfahren entfernt wird.

8. Halbleiterbauelementherstellungsverfahren nach einem der vorangegangenen Ansprüche, wobei auf der Oberseite (102) und/oder auf der Unterseite (104) vor der Ausbildung der Maskenschicht (M) metallische Kontaktflächen ausgebildet werden.

9. Halbleiterbauelementherstellungsverfahren nach einem der vorangegangenen Ansprüche, wobei nach dem Aufbringen der Maskenschicht (M) ein Mesa-Ätzprozess durchgeführt wird.

10. Halbleiterbauelementherstellungsverfahren nach einem der vorangegangenen Ansprüche, wobei der Ritzrahmen auf einer Breite (B1) von mindestens 30 µm und höchstens 300 µm amorphisiert und/oder isoliert wird.

11. Halbleiterbauelementherstellungsverfahren nach einem der vorangegangenen Ansprüche, wobei für die Maskenschicht (M) ein Metall verwendet wird.

12. Halbleiterbauelementherstellungsverfahren nach einem der vorangegangenen Ansprüche, wobei für die Maskenschicht (M) Titan oder Aluminium verwendet wird.

13. Vereinzeltes stapelförmiges Halbleiterbauelement (10), aufweisend eine Oberseite (12), einer Unterseite (14) und mindestens eine die Oberseite (12) mit der Unterseite (14) verbindende Seitenfläche (16),
- die Unterseite (14) von einer Substratschicht (SUB) oder einer unterhalb der Substratschicht (SUB) angeordneten Rückseitenkontaktschicht (K2) ausgebildet ist,
- auf der Substratschicht (SUB) jeweils eine erste Halbleiterschicht (HAI) von einem ersten Leitfähigkeitstyp angeordnet und auf der ersten Halbleiterschicht (HA1) mindestens eine zweite Halbleiterschicht (HA2) von einem zweiten Leitfähigkeitstyp angeordnet ist, wobei die beiden Halbleiterschichten (HA1, HA2) ein III-V Material aufweisen oder aus einem III-V Material bestehen und die beiden Leitfähigkeitstypen unterschiedlich sind,
- das die Oberseite (12) zumindest teilweise von einer Passivierungsschicht ausgebildet ist, wobei
- entlang der Seitenfläche (16) ein bis zu einer Tiefe (T1) sich erstreckender, durch Ionenimplantation erzeugter, amorphisierter und/oder isolierender Bereich (18) ausgebildet ist, wobei sich der Bereich (18) von der Oberseite (12) zur Unterseite (14) erstreckt und die Tiefe (T) senkrecht zum Schichtstapel ausgebildet ist.

14. Vereinzeltes stapelförmiges Hableiterbauelement (10) nach Anspruch 13, wobei die erste Halbleiterschicht (HA1) und die zweite Halbleiterschicht (HA2) jeweils eine GaAs-Verbindung aufweisen oder aus einer GaAs-Verbindung bestehen.

15. Vereinzeltes stapelförmiges Halbleiterbauelement (10) nach Anspruch 13 oder 14, wobei die Tiefe (T1) mindestens 0,5 µm oder mindestens 5 µm oder mindestens 30 µm beträgt oder Tiefenbereich zwischen der Oberseite (102) bis zu der ersten Halbleiterschicht (HA1) oder ein Tiefenbereich zwischen der Oberseite (102) und einschließlich der zweiten Halbleiterschicht (HA2) oder ein Tiefenbereich zwischen der Oberseite (102) bis Substratschicht (SUB) ausgebildet ist.

16. Vereinzeltes stapelförmiges Halbleiterbauelement (10) nach einem der Ansprüche 13 bis 15, wobei auf der Oberseite (12) und/oder auf der Unterseite (14) Gold, Silber und/oder Palladium aufweisende Kontaktflächen (K1) ausgebildet sind.

17. Vereinzeltes stapelförmiges Halbleiterbauelement (10) nach einem der Ansprüche 13 bis 16, wobei das Halbleiterbauelement (10) eine Gesamthöhe (H1) von mindestens 10 µm und höchstens 1000 µm aufweist.

## Claims

1. Method of semiconductor component manufacture, wherein
- a semiconductor semi-finished product (100) with an upper side (102) and a lower side (104) is provided, comprising a plurality of mutually adjacent semiconductor components (10) in stack configuration, wherein the semiconductor components (10) each comprise a substrate layer (SUB) with a III-V material or with germanium and the substrate layer (SUB) is arranged at or in the vicinity of the lower side (104), and on the substrate layer (SUB) a respective first semiconductor layer (HA1) of a first conductivity type is arranged and on the first semiconductor layer (HA1) at least one second semiconductor layer (HA2) of a second conductivity type is arranged, wherein the two semiconductor layers (HA1, HA2) comprise a III-V material or consist of a III-V material and the two conductivity types are different, and a scribe frame with a width (B1) is formed between two directly adjacent semiconductor components (10) on the upper side (102) of the semiconductor semifinished product (100),
- prior to application of a masking layer (100) the upper side (102) of the semiconductor semi-finished product (100) is coated by means of chemical gas phase deposition with a passivation layer (P) with a layer thickness of at least 100 nm and
- prior to separation a masking layer (M) covering the semiconductor components (10) and leaving free at least part of the scribe frame is applied to the upper side (102) of the semiconductor semi-finished product (100) and
- after application of the masking layer (M) an ion implantation for at least partial amorphisation and/or insulation is carried out and the ion implantation comprises at least one implantation step with an energy of at least 500 keV and
- after the ion implantation the masking layer (M) is removed and
- after removal of the masking layer (M) semiconductor components (10) are separated along the scribe frame.

2. Method of semiconductor component manufacture according to claim 1, **characterised in that** the first semiconductor layer (HA1) and the second semiconductor layer (HA2) each comprise a GaAs compound or consist of a GaAs compound.

3. Method of semiconductor component manufacture according to claim 1 or 2, wherein a depth region between the upper side (102) as far as the first semiconductor layer (HA1) or a depth region between the upper side (102) and inclusive of the second semiconductor layer (HA2) or a depth region between the upper side (102) as far as the substrate layer (SUB) is amorphised and/or insulated by means of the ion implantation.

4. Method of semiconductor component manufacture according to any one of the preceding claims, wherein hydrogen ions and/or helium ions are implanted.

5. Method of semiconductor component manufacture according to any one of the preceding claims, wherein an acceleration energy (E) of the ions during the implantation is varied between a minimum value (Emin) and a maximum value (Emax), wherein the minimum value (Emin) is at least 50 keV and the maximum value (Emax) is at most 300 MeV.

6. Method of semiconductor component manufacture according to any one of the preceding claims, wherein an implantation dose during the implantation is between 1010 cm⁻² and 1016 cm⁻².

7. Method of semiconductor component manufacture according to any one of the preceding claims, **characterised in that** the masking layer (M) is removed by a wet-chemical etching method prior to the separation.

8. Method of semiconductor component manufacture according to any one of the preceding claims, wherein metallic contact surfaces are formed on the upper side (102) and/or on the lower side (104) prior to formation of the masking layer (M).

9. Method of semiconductor component manufacture according to any one of the preceding claims, wherein a mesa etching process is carried out after application of the masking layer (M).

10. Method of semiconductor component manufacture according to any one of the preceding claims, wherein the scribe frame is amorphised and/or insulated to a width (B) of at least 30 µm and at most 300 µm.

11. Method of semiconductor component manufacture according to any one of the preceding claims, wherein a metal is used for the masking layer (M).

12. Method of semiconductor component manufacture according to any one of the preceding claims, wherein titanium or aluminium is used for the masking layer (M).

13. Separated semiconductor component (10) of stack configuration having an upper side (12), a lower side (14) and at least one side surface (16) connecting the upper side (12) with the lower side (14),
- the lower side (14) is formed by a substrate layer (SUB) or a rear side contact layer (K2) arranged below the substrate layer (SUB),
- a respective first semiconductor layer (HA1) of a first conductivity type is arranged on the substrate layer (SUB) and at least one second semiconductor layer (HA2) of a second conductivity type is arranged on the first semiconductor layer (HA1), wherein the two semiconductor layers (HA1, HA2) comprise a III-V material or consist of a III-V material and the two conductivity types are different,
- the upper side (12) is formed at least partly by a passivation layer, wherein
- an amorphised and/or insulated region (18) produced by ion implantation is formed along the side surface (16) to extend up to a depth (T1), wherein the region (18) extends from the upper side (12) to the lower side (14) and the depth (T) is formed perpendicularly to the layer stack.

14. Separated semiconductor component (10) of stack configuration according to claim 13, wherein the first semiconductor layer (HA1) and the second semiconductor layer (HA2) each comprise a GaAs compound or consist of a GaAs compound.

15. Separated semiconductor component (10) of stack configuration according to claim 13 or 14, wherein the depth (T1) is at least 0.5 µm or at least 5 µm or at least 30 µm or a depth region is formed between the upper side (102) as far as the first semiconductor layer (HA1) or a depth region is formed between the upper side (102) and inclusive of the second semiconductor layer (HA2) or a depth region is formed between the upper side (102) as far as the substrate layer (SUB).

16. Separated semiconductor component (10) of stack configuration according to any one of claims 13 to 15, wherein contact surfaces (K1) comprising gold, silver and/or palladium are formed on the upper side (12) and/or on the lower side (14).

17. Separated semiconductor component (10) of stack configuration according to any one of claims 13 to 16, wherein the semiconductor component (10) has a total height (H1) of at least 10 µm and at most 1000 µm.

## Revendications

1. Procédé pour la fabrication de composants semi-conducteurs, selon lequel
- est créé un produit semi-fini semi-conducteur (100) doté d'une face supérieure (102) et d'une face inférieure (104), comprenant une multitude de composants semi-conducteurs (10) en forme de piles disposés les uns à côté des autres, lesquels composants semi-conducteurs (10) comportent chacun une couche de substrat (SUB) avec un matériau III-V ou avec du germanium et laquelle couche de substrat (SUB) étant disposée sur ou à proximité de la face inférieure (104), une première couche semi-conductrice (HA1) d'un premier type de conductivité étant disposée sur la couche de substrat (SUB) et au moins une deuxième couche semi-conductrice (HA2) d'un deuxième type de conductivité étant disposée sur la première couche semi-conductrice (HA1), selon lequel les deux couches semi-conductrices (HA1, HA2) comportent un matériau III-V ou sont constituées d'un matériau III-V et les deux types de conductivité sont différents, et un cadre de découpe d'une largeur (B1) est créé entre deux composants semi-conducteurs (10) immédiatement voisins sur la face supérieure (102) du produit semi-fini semi-conducteur (100), la face supérieure (102) produit semi-fini semi-conducteur (100) est recouverte d'une couche de passivation (P) d'une épaisseur de couche d'au moins 100 nm par dépôt chimique en phase vapeur avant l'application d'une couche de masquage (M), et une couche de masquage (M) recouvrant les composants semi-conducteurs (10) et laissant dépasser au moins une partie du cadre de découpe est déposée sur la face supérieure (102) du produit semi-fini semi-conducteur (100) avant la séparation et
- une implantation ionique est réalisée après l'application de la couche de masquage (M) pour l'amorphisation au moins partielle et/ou l'isolation, laquelle implantation ionique comporte au moins une étape d'implantation avec une énergie d'au moins 500 keV et
- la couche de masquage (M) est retirée après l'implantation ionique et des composants semi-conducteurs (10) sont séparés le long du cadre de découpe après le retrait de la couche de masquage (M).

2. Procédé pour la fabrication de composants semi-conducteurs selon la revendication 1, **caractérisé en ce que** la première couche semi-conductrice (HA1) et la deuxième couche semi-conductrice (HA2) comprennent chacune un composé GaAs ou sont constituées d'un composé GaAs.

3. Procédé pour la fabrication de composants semi-conducteurs selon la revendication 1 ou 2, selon lequel une plage de profondeur entre la face supérieure (102) et la première couche semi-conductrice (HA1) ou une plage de profondeur entre la face supérieure (102) et la deuxième couche semi-conductrice (HA2) comprise ou une plage de profondeur entre la face supérieure et la couche de substrat (SUB) est amorphisée et/ou isolée au moyen de l'implantation ionique.

4. Procédé pour la fabrication de composants semi-conducteurs selon une des revendications précédentes, selon lequel des ions hydrogène et/ou des ions hélium sont implantés.

5. Procédé pour la fabrication de composants semi-conducteurs selon une des revendications précédentes, selon lequel une énergie d'accélération (E) des ions au cours de l'implantation varie entre une valeur minimale (Emin) et une valeur maximale (Emax), la valeur minimale (Emin) étant de 50 keV minimum et la valeur maximale (Emax) étant de 300 MeV maximum.

6. Procédé pour la fabrication de composants semi-conducteurs selon une des revendications précédentes, selon lequel une dose d'implantation au cours de l'implantation varie 1010 cm⁻² et 1016 cm⁻².

7. Procédé pour la fabrication de composants semi-conducteurs selon une des revendications précédentes, **caractérisé en ce que** la couche de masquage (M) est enlevée avant la séparation par un procédé d'attaque en voie chimique humide.

8. Procédé pour la fabrication de composants semi-conducteurs selon une des revendications précédentes, selon lequel des surfaces de contact métalliques sont formées sur la face supérieure (102) et/ou sur la face inférieure (104) avant la formation de la couche de masquage (M).

9. Procédé pour la fabrication de composants semi-conducteurs selon une des revendications précédentes, selon lequel un procédé d'attaque mesa est mis en oeuvre avant l'application de la couche de masquage (M).

10. Procédé pour la fabrication de composants semi-conducteurs selon une des revendications précédentes, selon lequel le cadre de découpe est amorphisé et/ou isolé sur une largeur de 30 µm minimum et de 300 µm maximum.

11. Procédé pour la fabrication de composants semi-conducteurs selon une des revendications précédentes, selon lequel un métal est utilisé pour la couche de masquage (M).

12. Procédé pour la fabrication de composants semi-conducteurs selon une des revendications précédentes, selon lequel du titane ou de l'aluminium est utilisé pour la couche de masquage (M).

13. Composant semi-conducteur (10) individuel en forme de pile comportant une face supérieure (12), une face inférieure (14) et au moins une face latérale (16) reliant la face supérieure (12) à la face inférieure (14),
- la face inférieure (14) est formée par une couche de substrat (SUB) ou une couche de contact arrière (K2) placée sous la couche de substrat (SUB),
- une première couche semi-conductrice (HA1) d'un premier type de conductivité est disposée sur la couche de substrat (SUB) et au moins une deuxième couche semi-conductrice (HA2) d'un deuxième type de conductivité est disposée sur la première couche semi-conductrice (HA1), les deux couches semi-conductrices (HA1, HA2) comportant un matériau III-V ou étant constituées d'un matériau III-V et les deux types de conductivité étant différents,
- que la face supérieure (12) est formée au moins partiellement par une couche de passivation,
- une zone (18) amorphisée et/ou isolante, générée par implantation ionique et s'étendant jusqu'à une profondeur (T1) étant formée le long de la face latérale (16), laquelle zone (18) s'étend de la face supérieure (12) à la face inférieure (14) et la profondeur étant perpendiculaire à l'empilement de couches.

14. Composant semi-conducteur (10) individuel en forme de pile selon la revendication 13, dans lequel la première couche semi-conductrice (HA1) et la deuxième couche semi-conductrice (HA2) comprennent chacune un composé GaAs ou sont constituées d'un composé GaAs.

15. Composant semi-conducteur (10) individuel en forme de pile selon la revendication 13 ou 14, dans lequel la profondeur (T1) est d'au moins 0,5 µm ou d'au moins 5 µm ou d'au moins 30 µm ou une plage de profondeur est comprise entre la face supérieure (102) et la première couche semi-conductrice (HA1) ou une plage de profondeur entre la face supérieure (102) et la deuxième couche semi-conductrice (HA2) ou une plage de profondeur entre la face supérieure (102) et la couche de substrat (SUB).

16. Composant semi-conducteur (10) individuel en forme de pile selon une des revendications 13 à 15, dans lequel des surfaces de contact (K1) comportant de l'or, de l'argent et/ou du palladium sont formées sur la face supérieure (12) et/ou la face inférieure (14).

17. Composant semi-conducteur (10) individuel en forme de pile selon une des revendications 13 à 165, lequel composant semi-conducteur (10) présente une hauteur totale (H1) de 10 µm minimum et de 1000 µm maximum.
